(19) Europäisches Patentamt European Patent Office Office européen des brevets

(11) **EP 3 862 763 B1**

(12) **EUROPÄISCHE PATENTSCHRIFT**

(45) Veröffentlichungstag und Bekanntmachung des Hinweises auf die Patenterteilung:
**17.08.2022   Patentblatt 2022/33**

(21) Anmeldenummer: **21152515.9**

(22) Anmeldetag: **20.01.2021**

(51) Internationale Patentklassifikation (IPC):
***G01R 27/18*** *(2006.01)*      ***G01R 31/54*** *(2020.01)*

(52) Gemeinsame Patentklassifikation (CPC):
**G01R 27/18; G01R 31/54**

(54) **VERFAHREN ZUR ÜBERWACHUNG EINES ERDWIDERSTANDS EINER ELEKTRISCHEN ANLAGE**

METHOD FOR MONITORING AN EARTH RESISTANCE OF AN ELECTRIC MACHINE

PROCÉDÉ DE SURVEILLANCE DE LA RÉSISTANCE DE LA TERRE D'UN SYSTÈME ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.02.2020   DE 102020102726**

(43) Veröffentlichungstag der Anmeldung:
**11.08.2021   Patentblatt 2021/32**

(73) Patentinhaber: **Bender GmbH & Co. KG**
**35305 Grünberg (DE)**

(72) Erfinder: **BRÖCKMANN, Eckhard**
**35396 Gießen (DE)**

(74) Vertreter: **advotec.**
**Patent- und Rechtsanwaltspartnerschaft**
**Tappe mbB**
**Georg-Schlosser-Straße 6**
**35390 Gießen (DE)**

(56) Entgegenhaltungen:
**DE-A1-102012 019 094      DE-A1-102013 209 142**
**DE-B3-102016 202 021**

**Beschreibung**

Die Erfindung betrifft ein Verfahren zur Überwachung eines Erdwiderstands einer elektrischen Anlage, die aus einem ungeerdeten stationären Wechselspannungs-Stromversorgungssystem mit mindestens einem aktiven Leiter und einem an das stationäre Wechselspannungs-Stromversorgungssystem über eine Zuleitung angeschlossenen Verbraucher besteht.

In der hier betrachteten Anwendungsumgebung umfasst das ungeerdete stationäre Wechselspannungs-Stromversorgungssystem mindestens einen aktiven Leiter und wird von einem Transformator gespeist. Das Wechselspannungs-Stromversorgungssystem kann ein einphasiges oder ein mehrphasiges ungeerdetes Stromversorgungssystem sein und zusätzlich einen Stromrichter (Gleichrichter) aufweisen. Der Verbraucher ist vorzugsweise über eine Steckverbindung und eine Zuleitung mit dem Wechselspannungs-Stromversorgungssystem verbunden und weist einen gegen einen Schutzleiter der Zuleitung geschalteten Ableitkondensator auf.

Für die Versorgung von elektrischen Betriebsmitteln (Verbraucher) kommt bei erhöhten Anforderungen an die Betriebs-, Brand- und Berührungssicherheit die Netzform eines ungeerdeten Stromversorgungssystems zum Einsatz, die auch als isoliertes Netz (frz. Isole Terre - IT) oder IT-System bezeichnet wird. Bei dieser Art des Stromversorgungssystems sind dessen aktiven Teile von dem Erdpotenzial - gegenüber Erde - getrennt. Der Vorteil des hier betrachteten ungeerdeten stationären Wechselspannungs-Stromversorgungssystems liegt darin, dass bei einem ersten Isolationsfehler die Funktion der elektrischen Betriebsmittel nicht beeinträchtigt wird, da sich wegen der fehlenden Schutzleiterverbindung und somit wegen des im Idealfall unendlich großen Impedanzwertes zwischen den aktiven Leitern des Netzes und Erde in diesem ersten Fehlerfall kein geschlossener Stromkreis ausbilden kann.

Wird dieses ungeerdete stationäre Wechselspannungs-Stromversorgungssystem mit einem Verbraucher verbunden, dessen Zuleitung einen Schutzleiter aufweist, so muss sichergestellt werden, dass dieser Schutzleiter ordnungsgemäß mit dem Erdpotenzial verbunden ist und der Erdwiderstand dieser Schutzleiterverbindung einen vorgegebenen Widerstandsgrenzwert nicht überschreitet.

Der Erdwiderstand soll definitionsgemäß die Summe der Widerstände des Schutzleiters in der Zuleitung und der Steckkontakte bzw. Klemmverbindungen umfassen.

Die hier betrachtete elektrische Anlage kann beispielsweise eine Ladestation für Elektrofahrzeuge sein, wobei die Ladestation über das ungeerdete stationäre ein- oder mehrphasige Wechselspannungs-Stromversorgungssystem gespeist wird. An die Ladestation ist mittels eines Lade-Steckersystems (Steckverbindung) über ein Ladekabel (Zuleitung) ein elektrischer Energiespeicher (Verbraucher) angeschlossen. Vorliegend wird davon ausgegangen, dass der Verbraucher über einen Ableitkondensator mit dem Schutzleiter der Zuleitung verbunden ist.. Im Falle eines Fehlers der Schutzleiterverbindung beispielsweise durch Leitungsbruch oder durch schadhafte Steckkontakte besteht eine erhöhte Berührungsgefahr für Personen. Derartige Fehler oder Beschädigungen des Schutzleiters treten relativ häufig auf, weshalb daher ein Interesse besteht, durch Messung des Erdwiderstands diese Fehler frühzeitig zu erkennen.

Zur Messung des Erdwiderstands ist stets ein Stromkreis erforderlich. Ein derartiger geschlossener Stromkreis kann sich aber in dem gegen Erde isolierten (ungeerdeten) stationären Wechselspannungs-Stromversorgungssystem nicht ausbilden.

Aus dem Stand der Technik sind daher spezielle Zuleitungen bekannt, die einen zusätzlichen Leiter, oft als Pilot-, Steuer oder Überwachungsleiter bezeichnet, enthalten, und ausschließlich dem Zweck der Messung des Erdwiderstands dienen, um zusammen mit dem Schutzleiter eine Stromschleife zu bilden. Gemessen wird ein Schleifenwiderstand, in dem auch der Erdwiderstand enthalten ist. Als Stand der Technik seien die Dokumente DE102012019094, DE102016202021 und DE102013209142 genannt.

Als nachteilig bei diesen bekannten Lösungen erweist es sich, dass immer ein gesonderter Leiter vorhanden sein muss, um einen geschlossenen Stromkreis ausbilden zu können.

Der vorliegenden Erfindung liegt somit die Aufgabe zugrunde, für eine oben beschriebene elektrische Anlage ein Verfahren zur Überwachung des Erdwiderstands vorzuschlagen, welches möglichst wenig zusätzlichen Installations- und Materialaufwand erfordert und damit kosteneffizient zu implementieren ist.

Diese Aufgabe wird mit den Merkmalen des Anspruchs 1 gelöst.

Die der Erfindung zugrunde liegende Idee besteht darin, auf die aus dem Stand der Technik bekannten zusätzlichen Leiter wie den Pilotleiter oder die separaten Steuer- oder Überwachungsleiter zu verzichten und stattdessen den/die ohnehin vorhandenen aktiven Leiter des stationären Wechselspannungs-Stromversorgungssystems und die Ableitkapazität des in dem Verbraucher verbautem Ableitkondensators zu verwenden, um einen Messstromkreis zur Überwachung eines Erdwiderstands auszubilden.

Ein zusätzlicher Leiter ist somit zur Ausbildung eines Stromkreises nicht erforderlich, da als Strompfad vorhandene kapazitive Elemente - die Ableitkapazität des Verbrauchers -genutzt werden. Bei entsprechend hoher Frequenz ist der kapazitive Leitwert dieser Elemente hinreichend groß, sodass sich ein Stromkreis ausbilden kann, der den Erdwiderstand umfasst.

Dazu wird zunächst ein Messsignal mit einer Messfrequenz im Bereich von vorzugsweise ca. 80 Hz bis 150 kHz mittels eines Messsignal-Generators erzeugt. In diesem Frequenzbereich ist der (Wechselstrom-)Widerstand der Ableitkondensatoren vernachlässigbar und es verbleibt lediglich als reeller Widerstand der innere Verlustwiderstand (ESR - Equivalent Series Resistance) der Ableitkondensatoren.

Das Messsignal wird kapazitiv in das stationäre Wechselspannungs-Stromversorgungssystem zwischen den aktiven Leiter und Erde über eine Ankoppelschaltung mit einem Ankoppelkondensator und einem Vorwiderstand eingekoppelt.

Der Ankoppelkondensator wird dabei so gewählt, dass er in dem genannten Frequenzbereich von ca. 80 Hz bis 150 kHz ebenfalls einen geringen (Wechselstrom) Widerstand aufweist. Der Vorwiderstand ist ein niederohmiger Widerstand, vorzugsweise kleiner als 1 Ohm, der als Shuntwiderstand der Strommessung dient, und kann als vorgegebener bekannter Wert bei den weiteren Messungen berücksichtigt werden.

Es erfolgt eine Messung eines komplexwertigen ersten Messstroms, der in der Ankoppelschaltung bei abgeschaltetem Verbraucher fließt. Dieser erste Messstrom fließt in dem Messstromkreis, der sich über die unvermeidlich vorhandene Wicklungskapazität des Transformators gegen Erde schließt.

Gleichzeitig mit der Messung des ersten Messstroms erfolgt die Ermittlung einer komplexwertigen ersten Messspannung zwischen dem aktiven Leiter des ungeerdeten stationären Wechselspannungs-Stromversorgungssystems und Erde.

Aus dem ersten Messstrom und der ersten Messspannung wird dann gemäß dem ohmschen Gesetz ein komplexwertiger erster Leitwert bestimmt.

Im nächsten Schritt wird ein komplexwertiger zweiter Messstrom in dem Ankoppelpfad bei zugeschaltetem Verbraucher gemessen. Dieser zweite Messstrom setzt sich zusammen aus dem ersten Messstrom und einem über die Ableitkapazität des angeschlossenen Verbrauchers fließenden Verbraucherstrom.

Gleichzeitig mit der Messung des zweiten Messstroms wird bei zugeschaltetem Verbraucher eine komplexwertige zweite Messspannung zwischen dem aktiven Leiter des ungeerdeten stationären Wechselspannungs-Stromversorgungssystems und Erde gemessen.

Aus dem zweiten Messstrom und der zweiten Messspannung wird dann ein komplexwertiger zweiter Leitwert gemäß dem ohmschen Gesetz bestimmt.

Anschließend erfolgt durch Differenzbildung zwischen dem zweiten Leitwert und dem ersten Leitwert das Berechnen eines komplexwertigen lastseitigen Leitwertes. Dieser lastseitige Leitwert lässt sich somit als Differenz zwischen dem zweiten Leitwert und dem ersten Leitwert darstellen.

Durch Kehrwertbildung des lastseitigen Leitwertes ergibt sich eine komplexwertige lastseitige Impedanz.

Diese komplexwertige lastseitige Impedanz umfasst in ihrem Realteil den zu überwachenden Erdwiderstand. Um diesen bewerten zu können, erfolgt die Berechnung eines Summen-Erdwiderstands, der sich durch Subtraktion des Vorwiderstands und der Subtraktion der Verlustwiderstände des Ableitkondensators und des Ankoppelkondensators von dem Realteil der komplexwertigen lastseitigen Impedanz ergibt. Der Summen-Erdwiderstand umfasst weiterhin neben dem zu ermittelnden Erdwiderstand noch den ohmschen Widerstand der Zuleitung, der allerdings bei der Messung nicht von dem eigentlichen Erdwiderstand unterschieden werden kann. Sollte daher der Summen-Erdwiderstand einen vorgegebenen Erdwiderstandsgrenzwert überschreiten, so muss im Zweifelsfall angenommen werden, dass der Erdwiderstand zu groß ist und es wird eine entsprechende Alarmierung erfolgen.

In weiterer Ausgestaltung erfolgt das Messen des ersten und des zweiten Messstroms mittels eines Spannungsabgriffs an dem Vorwiderstand und einer parallel zu dem Vorwiderstand liegenden Strom-Messschaltung.

Die Strom-Messschaltung ist als Hochpass mit einem Strom-Messkondensator und einem Strom-Messwiderstand ausgeführt.

Das Ermitteln der ersten und der zweiten Messspannung erfolgt durch Messen mittels einer kapazitiven Spannungs-Messschaltung.

Die Spannungs-Messschaltung ist ebenfalls als Hochpass mit einem Spannungs-Messkondensator und einem Spannungs-Messwiderstand ausgeführt.

Alternativ zu dem Ermitteln durch Messung können die erste und zweite Messspannung durch Verwendung einer bekannten Messsignal-Generatorspannung des Messsignal-Generators bestimmt werden.

Bevorzugt erfolgt das Bestimmen des ersten Leitwertes und des zweiten Leitwertes durch Berechnung von Fourierkoeffizienten der Messfrequenz des ersten und zweiten Messstroms und der ersten und zweiten Messspannung.

Bei der Anwendung des Verfahrens in einem dreiphasigen ungeerdeten stationären Wechselspannungs-Stromversorgungssystem erfolgt die Einkopplung des Messsignals mittels der Ankopplungsschaltung derart, dass in der Ankoppelschaltung zu jedem aktiven Leiter ein Ankoppelkondensator geschaltet ist und dass die Ankoppelschaltung den Vorwiderstand als gemeinsamen Ankoppelwiderstand aufweist.

Somit ergibt sich in einem dreiphasigen ungeerdeten stationären Wechselspannungs-Stromversorgungssystem die parallele Schaltung von drei Ankoppelkondensatoren, die mit einem gemeinsamen Ankoppelwiderstand verbunden sind.

Weiterhin erfolgt bei der Anwendung des Verfahrens in einem dreiphasigen ungeerdeten stationären Wechselspannungs-Stromversorgungssystem mit einem Stromrichter das Berechnen des Summen-Erdwiderstands durch zusätzliche Subtraktion von differentiellen Diodenwiderständen des Stromrichters und durch zusätzliche Subtraktion der Verlustwiderstände von Stromrichterableitkondensatoren.

Mit Vorteil erfolgt ein Umschalten der Messfrequenz zwischen zwei Messfrequenzen.

Insbesondere im Fall des installierten Gleichrichters können durch Messungen mit zwei unterschiedlichen Frequenzen die Kapazitäten der Stromrichterableitkondensatoren rechnerisch eliminiert werden.

Weitere vorteilhafte Ausgestaltungsmerkmale ergeben sich aus der nachfolgenden Beschreibung und den Zeichnungen, die bevorzugte Ausführungsformen der Erfindung anhand von Beispielen erläutern.

Es zeigen:

Fig. 1    Eine Anwendung des erfindungsgemäßen Verfahrens in einem dreiphasigen Wechselspannungs-Stromversorgungssystem mit angeschlossenem Verbraucher;

Fig. 2    ein elektrisches Ersatzschaltbild zu Fig. 1;

Fig. 3    ein Kabelmodell der Zuleitung mit Leitungsbelägen;

Fig. 4    eine kapazitive Spannungs-Messschaltung;

Fig. 5    eine Einkopplung des Messsignals sowie eine Strom- und eine Spannungs-Messschaltung mit analoger Signalaufbereitung;

Fig. 6    eine Einkopplung des Messsignals sowie eine Strom- und eine Spannungs-Messschaltung mit digitaler Signalaufbereitung;

Fig. 7    eine Anwendung des erfindungsgemäßen Verfahrens in einem dreiphasigen Wechselspannungs-Stromversorgungssystem mit Gleichrichter.

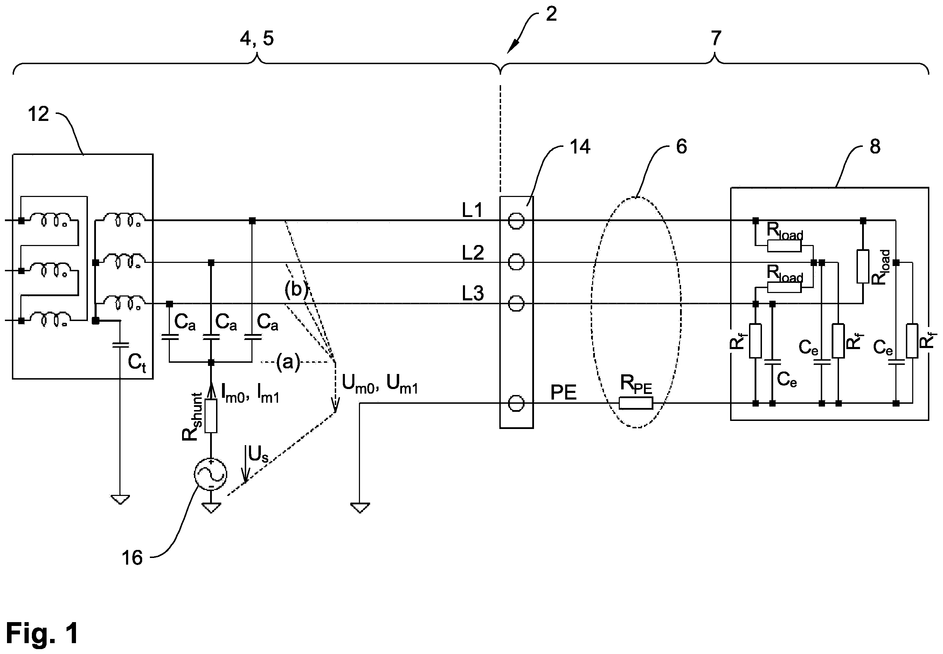

**Fig. 1** zeigt eine beispielhafte Anwendung des erfindungsgemäßen Verfahrens zur Überwachung eines Erdwiderstands $R_{PE}$ für eine elektrische Anlage 2. Die elektrische Anlage 2 besteht aus einem dreiphasigen ungeerdeten stationären Wechselspannungs-Stromversorgungssystem 4 mit drei aktiven Leitern L1, L2, L3 und einem über eine Steckverbindung 14 und eine Zuleitung 6 an das stationäre Wechselspannungs-Stromversorgungssystem 4 angeschlossenen Verbraucher 8.

Die elektrische Anlage 2 kann in einen das stationäre Wechselspannungs-Stromversorgungssystem 4 umfassenden stationären Bereich 5 und einen die Steckverbindung 14, die Zuleitung 6 und den Verbraucher 8 umfassenden temporären Bereich 7 untergliedert werden.

Das stationäre Wechselspannungs-Stromversorgungssystem 4 wird von einem Transformator 12 gespeist, dessen Wicklungen jeweils eine Wicklungskapazität Ct gegen Erde besitzen.

Der Verbraucher 8 ist durch die Lastwiderstände $R_{load}$ charakterisiert. Vorausgesetzt wird, dass der Verbraucher 8 für jede Phase entsprechend den aktiven Leitern L1, L2, L3 einen üblicherweise vorhandenen Ableitkondensator $C_e$ gegen Erde aufweist. Weiterhin sind parallel zu den Ableitkondensatoren $C_e$ geschaltete Isolationswiderstände $R_f$ dargestellt, die aber hier als hinreichend hochohmig und damit für die weiteren Betrachtungen als vernachlässigbar angenommen werden können.

Aufgabengemäß ist der Erdwiderstand $R_{PE}$ des Schutzleiters PE zu überwachen, um beispielsweise einen Leitungsbruch des Schutzleiters PE oder fehlerhafte Steckverbindungen 14 rechtzeitig zu erkennen. Der Erdwiderstand $R_{PE}$ ist hier als konzentriertes Element der Zuleitung 6 zugeordnet, umfasst aber, wie oben erläutert, definitionsgemäß den Widerstand des Schutzleiters PE in der Zuleitung 6, einen Widerstand der Steckverbindung 14 und gegebenenfalls Widerstände weiterer Klemmverbindungen.

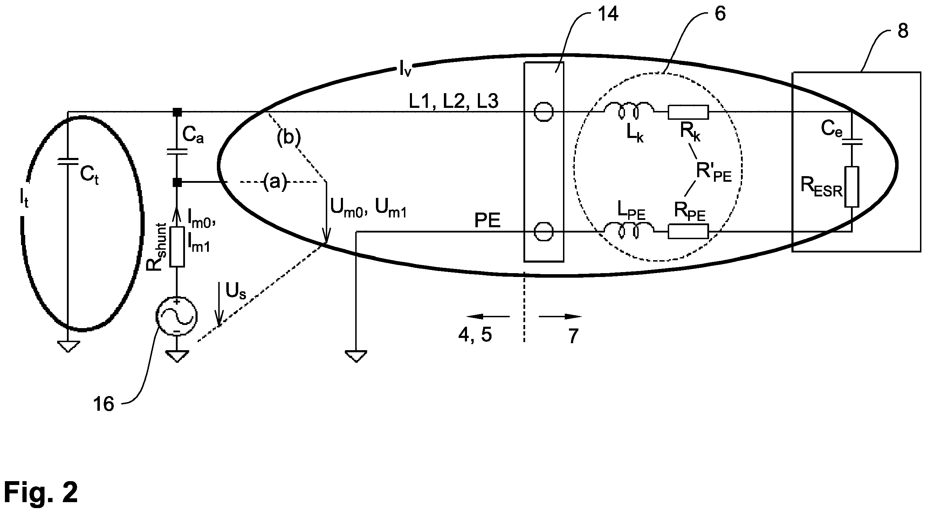

Der Erdwiderstand $R_{PE}$ wird erfindungsgemäß ohne das Erfordernis einer zusätzlichen Signalleitung überwacht. Dazu wird zunächst in einem Messsignal-Generator 16 ein Messsignal Us mit einer Messfrequenz im Bereich von ca. 80 Hz bis 150 kHz erzeugt. Dieses Messsignal Us wird über eine Ankoppelschaltung, welche aus den Ankoppelkondensatoren Ca und dem Vorwiderstand $R_{shunt}$ besteht, zwischen jeden aktiven Leiter L1, L2, L3 und Erde kapazitiv eingekoppelt. Dabei schließt sich bei abgeschaltetem Verbraucher ein Messstromkreis für einen ersten Messstrom $I_{m0}$ ausschließlich über die Wicklungskapazität Ct des einspeisenden Transformators 12. Im Falle des angeschlossenen Verbrauchers 8 ergibt sich ein zweiter Messstrom $I_{m1}$, der zusätzlich zu dem ersten Messstrom $I_{m0}$ einen Verbraucherstrom $I_v$ (Fig. 2) umfasst, der über die in dem Verbraucher 8 installierten Ableitkondensatoren $C_e$ und den Erdwiderstand $R_{PE}$ fließt.

**Fig. 2** zeigt ein Ersatzschaltbild zu der in Fig. 1 beschriebenen Konstellation, um den Stromfluss des ersten und des zweiten Messstroms $I_{m0}$, $I_{m1}$ sowie die Messung einer ersten und einer zweiten Messspannung $U_{m0}$, $U_{m1}$ zu verdeutlichen.

Die aktiven Leiter L1, L2, L3 sind dabei vereinfachend als ein einziger aktiver Leiter dargestellt. Die hochohmigen Isolationswiderstände $R_f$ können vernachlässigt werden.

Falls der Verbraucher abgeschaltet oder nicht angeschlossen ist und da aber zumindest eine Wicklungskapazität Ct in dem Transformator 12 vorhanden ist, fließt ein von dem Messsignal Us getriebener Transformatorstrom $I_t$ in dem stationären Bereich 5, der dem ersten Messstrom $I_{m0}$ entspricht. Weitere hochohmige, parallel zu der Wicklungskapazität Ct liegende Isolationswiderstände können wiederum vernachlässigt werden. Andere bewusst verbaute Ableitkondensatoren im stationären Bereich wirken genauso wie Wicklungskapazität Ct.

Im Falle eines zugeschalteten Verbrauchers ist der in dem temporärem Bereich 7 fließende Verbraucherstrom $I_v$ begrenzt durch

den Vorwiderstand $R_{shunt}$ ,
den Ankoppelkondensator Ca bzw. bei dreiphasigem Netz die Parallelschaltung von drei Ankoppelkondensatoren $C_a$ ,
den Verlustwiderstand $R_{ESR}$ dieser Ankoppelkondensatoren $C_a$.,
eine (Zu-)Leitungsinduktivität $L_k$ der Zuleitung,
den ohmschen Widerstand $R_k$ der Zuleitung inklusive der Kontaktwiderstände der eventuell vorhandenen Steckverbindung 14,
den Ableitkondensator $C_e$ des Verbrauchers 8 bzw. die Parallelschaltung aller Ableitkondensatoren $C_e$ im Verbraucher,
die Verlustwiderstände der Ableitkondensatoren $C_e$ im Verbraucher,
die Induktivität $L_{PE}$ des Schutzleiters PE in der Zuleitung 6 und den Erdwiderstand $R_{PE}$ des Schutzleiters PE inklusive des zugehörigen Kontaktwiderstands einer eventuell vorhandenen Steckverbindung 14.

Bei hoher Frequenz des Messsignals Us wird der Leitwert der Ableitkondensatoren Ca sowie der kapazitive Leitwert der Transformatorwicklung so groß, dass ein durch das Messsignal Us getriebener erster Messstrom $I_{m0}$ (bei abgeschaltetem Verbraucher) und hinreichend großer zweiter Messstrom $I_{m1}$ (bei zugeschaltetem Verbraucher) fließen, die zur Messung des Erdwiderstands $R_{PE}$ geeignet sind.

In Verbindung mit den Messungen der ersten Messspannung $U_{m0}$ bei abgeschaltetem Verbraucher und der zweiten Messspannung $U_{m1}$ bei zugeschaltetem Verbraucher können nun ein erster Leitwert $Y_{m0}$, der einem transformatorseitigen Leitwert Yt entspricht und welcher dem Transformatorstrom $I_t=I_{m0}$, also dem ersten Messstrom $I_{m0}$, zugeordnet ist, und ein zweiter Leitwert $Y_{m1}$, welcher dem zweiten Messstrom $I_{m1}$ zugeordnet ist, bestimmt werden. Durch Differenzbildung zwischen dem zweiten Leitwert $Y_{m1}$ und dem ersten Leitwert $Y_{m0}$ ergibt sich der komplexwertige lastseitige Leitwert $Y_v$.

Messung ohne Verbraucher:

$$Y_{m0} = Y_t$$

Messung mit Verbraucher:

$$Y_{m1} = Y_t + Y_v$$

$$Y_v = Y_{m1} - Y_{m0}$$

Durch Kehrwertbildung des lastseitigen Leitwertes $Y_v$ erhält man die komplexwertige lastseitige Impedanz $Z_v$, deren Realteil den Erdwiderstand $R_{PE}$ enthält.

Der Imaginärteil der lastseitigen Impedanz $Z_v$ spielt in den weiteren Betrachtungen keine Rolle.

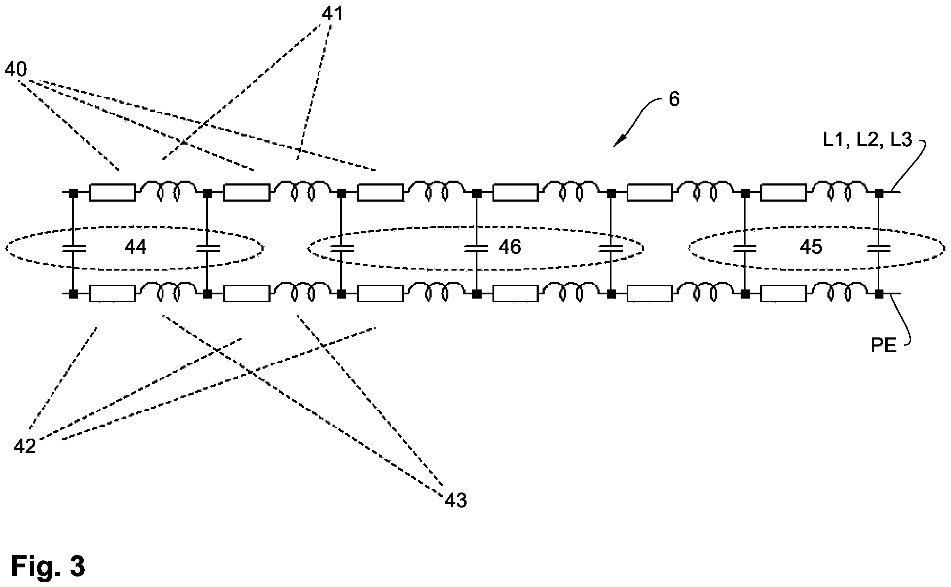

Der Realteil der lastseitigen Impedanz $Z_v$ umfasst allerdings alle ohmschen Anteile, also neben dem zu überwachenden Erdwiderstand $R_{PE}$ auch sämtliche Verlustwiderstände, den Vorwiderstand $R_{shunt}$ und den differentiellen Widerstand (Widerstandsbelag 60) (siehe Fig. 3) und müssen daher von den Realteil der lastseitigen Impedanz $Z_V$ subtrahiert werden.

Da die Werte der Verlustwiderstände $R_{ESR}$ sehr klein sind, genügt zu deren Subtraktion die Kenntnis aus Datenblättern. Der Vorwiderstand $R_{shunt}$ ist ein Widerstand mit einem vorgegebenen, genau bekannten Wert.

Es verbleibt somit ein Summen-Erdwiderstand $R'_{PE}$, der sich aus der Summe des (Zu-)Leitungswiderstands

$R_k$ und dem (eigentlichen) Erdwiderstand $R_{PE}$ zusammensetzt. Messtechnisch kann zwischen dem Leitungswiderstand $R_k$ und dem Erdwiderstand $R_{PE}$ nicht unterschieden werden. Sollte der Summen-Erdwiderstand $R'_{PE}$ einen Erdwiderstandsgrenzwert $R_{PElim}$ überschreiten, so muss im Zweifelsfall angenommen werden, dass der Erdwiderstand $R_{PE}$ unzulässig groß ist und es wird eine entsprechende Alarmierung erfolgen oder das System ist abzuschalten.

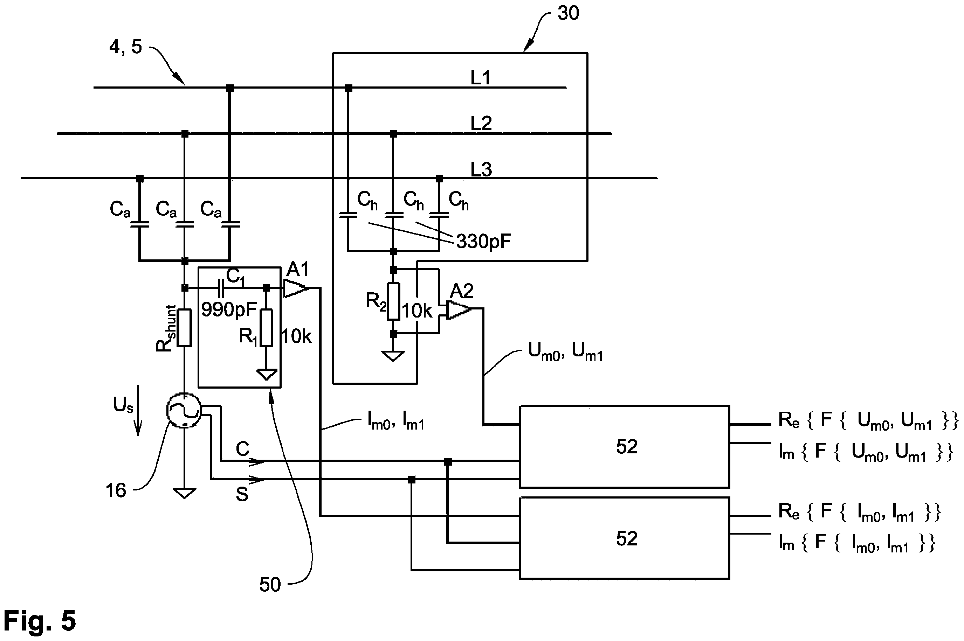

Die Bestimmung der komplexwertigen Leitwerte $Y_{m0}$, $Y_{m1}$, $Y_v$ erfordert Strommessungen und Spannungsmessungen mit definierten Phasenlagen. Die Strommessung erfolgt über einen Messwiderstand $R_{shunt}$ (Shunt-Widerstand) als Stromsensor. Ein nachgeschalteter Breitbandverstärker A1 (Fig. 5) muss breitbandig ausgelegt sein, damit dessen Ausgangssignal nur eine sehr kleine Phasenverschiebung zur jeweils tatsächlichen Phasenlage der realen Ströme $I_{m0}$, $I_{m1}$ aufweist.

Der Abgriff der komplexwertigen ersten und zweiten Messspannungen $U_{m0}$, $U_{m1}$ zwischen dem aktiven Leiter L1, L2, L3 und Erde kann über den Messpfad (b) direkt an den aktiven Leiter L1, L2, L3 führen oder über den Messpfad (a), der eine direkte Ankopplung an den aktiven Leiter L1, L2, L3 vermeidet. Allerdings verschlechtert sich die Messgenauigkeit bei Messpfad (a), da an dem Ankoppelkondensator Ca eine zusätzliche Spannung abfällt.

Prinzipiell kann auch die Messung der ersten und der zweiten Messspannung $U_{m0}$, $U_{m1}$ entfallen, wenn der Messsignal-Generator 16 bei unterschiedlichen Belastungen eine stabile bekannte Ausgangsamplitude erzeugt und wenn das erzeugte Ausgangssignal stets in einer festen oder bekannten Phasenbeziehung zu einer anderweitig erzeugten Phasenreferenz steht. In diesem Fall kann also eine bekannte Messsignal-Generatorspannung das Messen der ersten und der zweiten Messspannung $U_{m0}$, $U_{m1}$ ersetzen.

Durch Integration über mindestens eine Periode der gemessenen Messströme $I_{m0}$, $I_{m1}$ und der gemessenen Messspannungen $U_{m0}$, $U_{m1}$ können deren Fourierkoeffizienten bestimmt werden und daraus der erste Leitwert $Y_{m0}$ (bei abgeschaltetem Verbraucher) und der zweite Leitwert (bei zugeschaltetem Verbraucher) berechnet werden.

Messung ohne Verbraucher:
$$Y_{m0} = \frac{F\{I_{m0}\}}{F\{U_{m0}\}}$$

$$Y_{m1} = \frac{F\{I_{m1}\}}{F\{U_{m1}\}}$$

Messung mit Verbraucher:

Aus Differenzbildung ergibt sich der lastseitige Leitwert $Y_v$

$Y_v = Y_{m1} - Y_{m0}$ und aus der Kehrwertbildung

$$Z_v = \frac{1}{Y_v}$$ ergibt sich als Realteil

$$R_k + R_{PE} = Re\{Z_v\} - R_{shunt} - ESR\_Werte$$

Dieser Realteil entspricht dem Summen-Erdwiderstand $R'_{PE}$. Der Imaginärteil kann beliebige Werte annehmen und wird nicht ausgewertet.

Bei der Berechnung der Fourierkoeffizienten wird vorausgesetzt, dass die Kosinusfunktion und die dazu orthogonale Sinusfunktion mit einer internen Phasenreferenz vorhanden sind. Alternativ können auch Vektor-Lock-in-Verstärker verwendet werden.

Fig. 2 kann auch als Ersatzschaltbild herangezogen werden, falls durch Zuschalten des Verbrauchers 8 zusätzliche Kapazitäten wirksam werden, die den Strompfad, bestehend aus Zuleitung 6, einer gegebenenfalls vorhandenen Steckverbindung 14 und dem Ableitkondensator $C_e$, in einer Parallelschaltung überbrücken. Dies wäre beispielsweise der Fall bei einer Steckverbindung 14, die einen Funkentstörkondensator enthält.

Fig. 3 zeigt ein Kabelmodell der Zuleitung 6 mit Leitungsbelägen 40 bis 46.

Ausgangseitig wirkende Leitungskapazitäten können als Parallelschaltung zu den Ableitkondensatoren $C_e$ angesehen werden und haben den gleichen Effekt wie diese. Da jedoch ohmsche, kapazitive und induktive Widerstände kontinuierlich (differentiell) über die Leitung verteilt sind (Widerstands-, Kapazitäts-, Induktivitätsbelag) sind Messfehler nicht zu vermeiden.

Alle differentiellen Widerstände 40 (Widerstandsbelag) der aktiven Leiter L1, L2, L3 sind Bestandteil des Leitungswiderstands $R_k$ und gehen in das Messergebnis ein. Differentielle Induktivitäten 41 (Induktivitätsbelag) der aktiven Leiter L1, L2, L3 sind Bestandteil der Leitungsinduktivität $L_k$ und können ignoriert werden, da sie zu dem Imaginärteil der lastseitigen Impedanz $Z_v$ gehören. Entsprechendes gilt für die differentiellen Widerstände 42 des Schutzleiters PE und für die differentiellen Induktivitäten 43 des Schutzleiters PE.

Differentielle Kapazitäten 44, die an dem Eingang der Zuleitung 6 in Erscheinung treten, können in einem Messverfahren mit zwei Frequenzen eliminiert werden. Differentielle Kapazitäten 45, die am Ausgang der Zuleitung 6 in Erscheinung treten, können in guter Näherung als Parallelschaltung zu den Ableitkondensatoren $C_e$ angesehen werden und erzeugen nur sehr kleine Messfehler. Differentielle Kapazitäten 46, die den mittleren Bereich der Zuleitung 6 zugeordnet werden können, wirken einer Schleifenmessung entgegen und können ebenfalls Messfehler erzeugen.

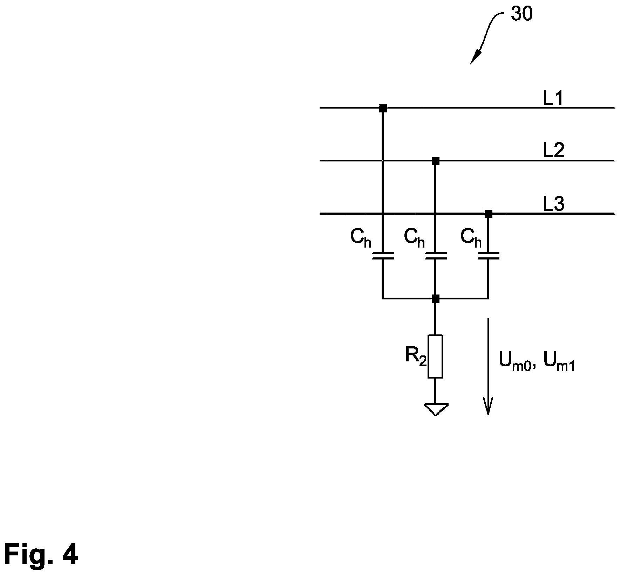

Fig. 4 zeigt das Messen der ersten und der zweiten Messspannung $U_{m0}$, $U_{m1}$ mittels einer kapazitiven Spannungs-Messschaltung 30 in einem dreiphasigen ungeerdeten stationären Wechselspannungs-Stromversorgungssystem 4.

Der gezeigte Spannungsabgriff entspricht dem Messpfad (b) in den Fig. 1 und 2. Die Spannungs-Messschaltung 30 ist als Hochpass mit je einem Spannungs-Messkondensator $C_h$ für jeden aktiven Leiter L1, L2, L3 ausgeführt, wobei die Spannungs-Messkondensatoren $C_h$ über einen gemeinsamen Spannungs-Messwiderstand $R_2$ gegen Erde geschaltet sind. Die erste und die zweite Messspannung $U_{m0}$, $U_{m1}$ werden über den Spannungs-Messwiderstand $R_2$ abgegriffen.

Fig. 5 zeigt die Einkopplung des Messsignals Us sowie eine Strom-Messschaltung 50 und eine Spannungs-Messschaltung 30 mit analoger Signalaufbereitung in einem dreiphasigen ungeerdeten stationären Wechselspannung-Stromversorgungssystem 4.

Das von dem Messsignal-Generator 16 erzeugte Messsignal Us gelangt über den Vorwiderstand $R_{shunt}$ und die Ankoppelkondensatoren Ca in die aktiven Leiter L1, L2, L3 des Wechselspannungs-Stromversorgungssystems 4.

Die Messung des ersten und des zweiten Messstroms $I_{m0}$, $I_{m1}$ erfolgt über eine Strom-Messschaltung 50, die zur Unterdrückung der Netzspannung vorteilhaft als Hochpass ausgeführt ist. Als Eingangssignal für diesen Hochpass dient eine über dem Vorwiderstand $R_{shunt}$ abgegriffene Spannung. Der Hochpass umfasst einen Strom-Messkondensator $C_1$ und einen Strom-Messwiderstand $R_1$. Das Ausgangssignal des Hochpasses wird als erster bzw. zweiter Messstrom $I_{m0}$, $I_{m1}$ an den Breitbandverstärker A1 weitergegeben.

Die Messung der ersten und der zweiten Messspannung $U_{m0}$, $U_{m1}$ erfolgt gemäß der in Fig. 4 dargestellten kapazitiven Spannungs-Messschaltung 30, die ebenfalls als Hochpass mit den Spannungs-Messkondensatoren $C_h$ und dem Spannungs-Messwiderstand $R_2$ ausgeführt ist.

Man erkennt, dass die jeweilige Zeitkonstante der beiden Hochpässe 30, 50 gleich ist - $C_1$ besitzt eine Kapazität von 990 pF, was der Kapazität der drei parallel geschalteten Spannungs-Messkondensatoren $C_h$ mit je einer Kapazität von 330 pF entspricht. Der Strom-Messwiderstand $R_1$ und der Spannungs-Messwiderstand $R_2$ besitzen den gleichen Wert von 10 kΩ. Aufgrund der gleichen Zeitkonstanten ergibt sich auch eine gleiche Phasenverschiebung. Eine Differenz der Phasenverschiebung ist aber zulässig, wenn diese im Rahmen einer Kalibrierung ermittelt wird.

Ein Breitbanddifferenzverstärker A2 verstärkt die erste und die zweite Messspannung $U_{m0}$, $U_{m1}$.

Der erste und der zweite Messstrom $I_{m0}$, $I_{m1}$ sowie die erste und die zweite Messspannung $U_{m0}$, $U_{m1}$ werden jeweils mit einem Vektor-Lock-in-Verstärker 52 zur Berechnung der Fourierkoeffizienten weiter verarbeitet. An den Ausgängen der jeweiligen Vektor-Lock-in-Verstärker 52 stehen der Realteil und der Imaginärteil des ersten und zweiten Messstroms $I_{m0}$, $I_{m1}$ sowie der ersten und zweiten Messspannung $U_{m0}$, $U_{m1}$ zur Verfügung.

Die weitere Auswertung erfolgt in einer digitalen Recheneinheit (nicht dargestellt) über Analog-Digital-Umsetzer (nicht dargestellt). Der Messsignal-Generator 16 ist mit synchronen orthogonalen Digitalausgängen C, S ausgestattet, welche als Phaseneingänge der Vektor-Lock-in-Verstärker 52 genutzt werden.

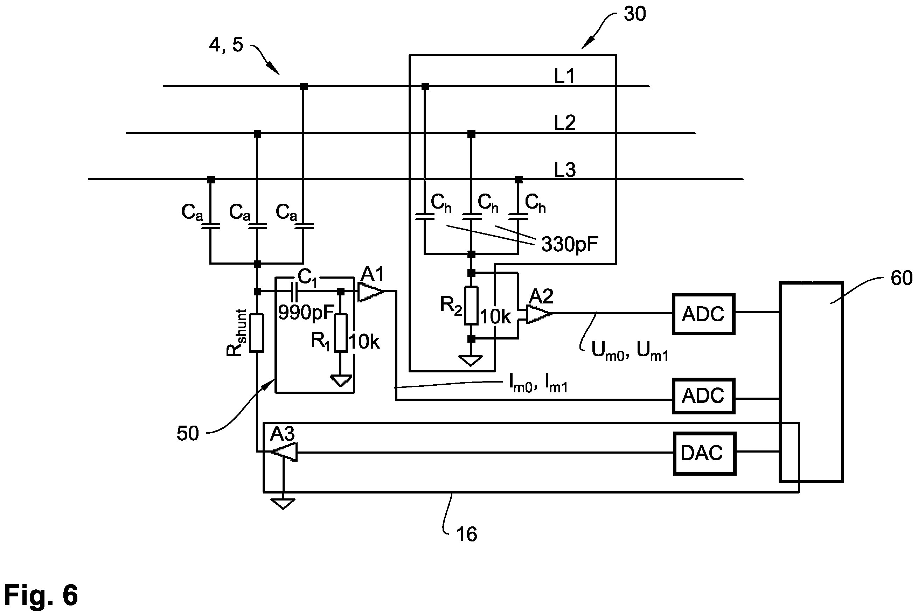

**Fig. 6** zeigt die Einkopplung des Messsignals Us sowie eine Strom-Messschaltung 50 und eine Spannungs-Messschaltung 30 mit digitaler Signalaufbereitung in einem dreiphasigen ungeerdeten stationären Wechselspannungs-Stromversorgungssystem 4.

Im Unterschied zu der in Fig. 5 dargestellten analogen Signalaufbereitung werden hier die Ausgangssignale - die erste und die zweite Messspannung $U_{m0}$, $U_{m1}$ der Spannungs-Messschaltung 30 und der erste und der zweite Messstrom $I_{m0}$, $I_{m1}$ der Strom-Messschaltung 50 nach der Verstärkung über die jeweiligen Breitbandverstärker A2, A1 einer Analog-Digital-Umsetzung ADC unterzogen und einer Recheneinheit 60 zugeführt. Die Berechnung der Fourierkoeffizienten kann in dieser Recheneinheit 60 mit verbesserter Selektivität erfolgen, indem Kosinus- und Sinuswerte anstelle der digitalen Rechtecksignale C und S (Fig. 5) verwendet werden. Der Messsignal-Generator 16 wird mit einem Digital-Analog-Umsetzer DAC und einer Leistungsstufe A3 realisiert.

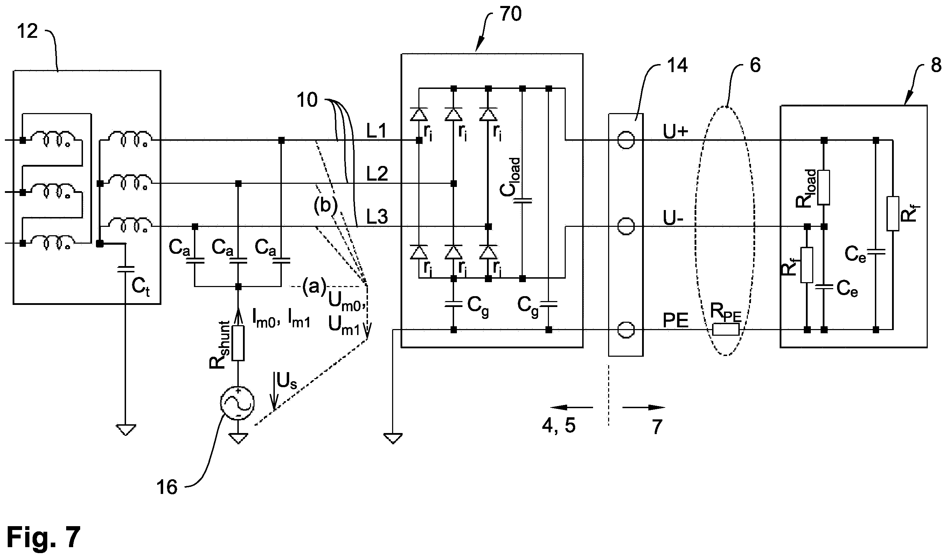

**Fig. 7** zeigt eine Anwendung des erfindungsgemäßen Verfahrens in einem dreiphasigen ungeerdeten stationären Wechselspannungs-Stromversorgungssystem 4 mit einem Gleichrichter 70.

Diese Konstellation entspricht einer Ladestation (stationärer Bereich 5 mit dreiphasigem ungeerdetem stationären Wechselspannungs-Stromversorgungssystem 4) mit angeschlossenem Elektrofahrzeug (temporärer Bereich 7 mit einem Ladestecker und einer Ladebuchse als Steckverbindung 14, einem Ladekabel als Zuleitung 6 und einem elektrischen Energiespeicher als Verbraucher 8).

Der Gleichrichter 70 ist dabei als B6-Gleichrichter ausgeführt, wobei bei zugeschaltetem Verbraucher 8 der differentielle Widerstand $r_i$ der Dioden berücksichtigt werden muss:

$$R_k + R_{PE} = Re\{Z_v\} - R_{shunt} - r_i - ESR\_Werte$$

Allerdings hängt der differentielle Widerstand $r_i$ der Dioden auch von dem Stromflusswinkel der Dioden ab. Dieser wird durch einen Ladekondensator $C_{load}$ sowie die Verbraucherlast $R_{load}$ bestimmt. Die Messung ist umso genauer, je kleiner $C_{load}$ ist und der Verbraucherstrom so groß ist, dass der differentielle Widerstand $r_i$ klein bleibt.

Gegebenenfalls vorhandene Gleichrichter-Ableitkondensatoren $C_g$ können über Messungen mit zwei verschiedenen Messfrequenzen und einer Auswerterechnung eliminiert werden.

**Patentansprüche**

**1.** Verfahren zur Überwachung eines Erdwiderstands ($R_{PE}$) einer elektrischen Anlage (2), die aus einem ungeerdeten stationären Wechselspannungs-Stromversorgungssystem (4) mit mindestens einem aktiven Leiter (L1, L2, L3) und einem an das stationäre Wechselspannungs-Stromversorgungssystem (4) über eine Zuleitung (6) angeschlossenen Verbraucher (8) besteht,

wobei das ungeerdete stationären Wechselspannungs-Stromversorgungssystem (4) von einem Transformator (12) gespeist wird und der Verbraucher (8) einen gegen einen Schutzleiter (PE) geschalteten Ableitkondensator ($C_e$) aufweist
umfassend die Verfahrensschritte:

Erzeugen eines Messsignals ($U_s$) mit einer Messfrequenz mittels eines Messsignal-Generators (16),
Kapazitives Einkoppeln des Messsignals ($U_s$) in das stationäre Wechselspannungs-Stromversorgungssystem (4) zwischen dem aktiven Leiter (L1, L2, L3) und Erde über eine Ankoppelschaltung mit einem Ankoppelkondensator ($C_a$) und mit einem Vorwiderstand ($R_{shunt}$), Messen eines komplexwertigen ersten Messstroms ($I_{m0}$) in der Ankoppelschaltung bei abgeschaltetem Verbraucher (8), ,
Ermitteln einer komplexwertigen ersten Messspannung ($U_{m0}$) zwischen dem aktiven Leiter (L1, L2, L3) und Erde bei abgeschaltetem Verbraucher (8),
Bestimmen eines komplexwertigen ersten Leitwertes ($Y_{m0}$) aus dem ersten Messstrom $I_{m0}$ und der ersten Messspannung ($U_{m0}$),
Messen eines komplexwertigen zweiten Messstroms ($I_{m1}$) in dem Ankoppelpfad bei zugeschaltetem Verbraucher (8),
Messen einer komplexwertigen zweiten Messspannung ($U_{m1}$) zwischen dem aktiven Leiter (L1, L2, L3) und Erde bei zugeschaltetem Verbraucher (8),
Bestimmen eines komplexwertigen zweiten Leitwertes ($Y_{m1}$) aus dem zweiten Messstrom ($I_{m1}$) und der zweiten Messspannung ($U_{m1}$),
Berechnen eines komplexwertigen lastseitigen Leitwertes ($Y_v$) durch Differenzbildung zwischen dem zweiten Leitwert ($Y_{m1}$) und dem ersten Leitwert ($Y_{m0}$)
Berechnen einer komplexwertigen lastseitigen Impedanz ($Z_v$) aus dem Kehrwert des lastseitigen Leitwertes ($Y_v$),
Berechnen eines Summen-Erdwiderstands ($R'_{PE}$) durch Subtraktion des Vorwiderstands ($R_{shunt}$) und Subtraktion von Verlustwiderständen ($R_{ESR}$) des Ableitkondensators ($C_e$) und des Ankoppelkondensators ($C_a$) von dem Realteil der komplexwertigen lastseitigen Impedanz ($Z_v$),
Erzeugen eines Alarmsignals, falls der Summen-Erdwiderstand ($R'_{PE}$) einen Erdwiderstandsgrenzwert ($R_{PElim}$) überschreitet.

**2.** Verfahren nach Anspruch 1,
**dadurch gekennzeichnet,**
**dass** das Messen des ersten und des zweiten Messstroms ($I_{m0}$, $I_{m1}$) mittels eines Spannungsabgriffs an dem Vorwiderstand ($R_{shunt}$) und einer parallel zu dem Vorwiderstand ($R_{shunt}$) liegenden Strom-Messschaltung (50) erfolgt, die als Hochpass mit einem Strom-Messkondensator ($C_1$) und einem Strom-Messwiderstand ($R_1$) ausgeführt ist.

**3.** Verfahren nach Anspruch 1 oder 2,
**dadurch gekennzeichnet,**
**dass** das Ermitteln der ersten und der zweiten Messspannung ($U_{m0}$, $U_{m1}$) durch Messen mittels einer kapazitiven Spannungs-Messschaltung (30) erfolgt, die als Hochpass mit einem Spannungs-Messkondensator ($C_h$) und einem Spannungs-Messwiderstand ($R_2$) ausgeführt ist.

**4.** Verfahren nach Anspruch 1 oder 2,
**dadurch gekennzeichnet,**

**dass** das Ermitteln der ersten und der zweiten Messspannung ($U_{m0}$, $U_{m1}$) durch Verwenden einer bekannten Messsignal-Generatorspannung des Messsignal-Generators (16) erfolgt.

5.  Verfahren nach einem der Ansprüche 1 bis 4,
    **dadurch gekennzeichnet,**
    **dass** das Bestimmen des ersten Leitwertes ($Y_{m0}$) und des zweiten Leitwertes ($Y_{m1}$) durch Berechnung von Fourierkoeffizienten ($F\{\}$) des ersten und zweiten Messstroms ($I_{m0}$, $I_{m1}$) und der ersten und zweiten Messspannung ($U_{m0}$, $U_{m1}$ ) erfolgt.

6.  Verfahren nach einem der Ansprüche 1 bis 5,
    **dadurch gekennzeichnet,**
    **dass** bei der Anwendung des Verfahrens in einem 3-phasigen ungeerdeten stationären Wechselspannungs-Stromversorgungssystem (4) die Einkopplung des Messsignals ($U_s$) mittels der Ankoppelschaltung derart erfolgt, dass in der Ankoppelschaltung zu jedem aktiven Leiter (L1, L2, L3) ein Ankoppelkondensator ($C_a$) geschaltet ist und dass die Ankoppelschaltung den Vorwiderstand ($R_{shunt}$) als gemeinsamen Ankoppelwiderstand aufweist.

7.  Verfahren nach einem der Ansprüche 1 bis 6,
    **dadurch gekennzeichnet,**
    **dass** bei der Anwendung des Verfahrens in einem 3-phasigen ungeerdeten stationären Wechselspannungs-Stromversorgungssystem (4) mit einem Stromrichter (70) das Berechnen des Summen-Erdwiderstands ($R'_{PE}$) durch zusätzliche Subtraktion von differentiellen Dioden-Widerständen ($r_i$) des Stromrichters (70) und durch zusätzliche Subtraktion der Verlustwiderstände von Stromrichter-Ableitkondensatoren ($C_g$) erfolgt.

8.  Verfahren nach einem der Ansprüche 1 bis 7,
    **dadurch gekennzeichnet,**
    **dass** ein Umschalten der Messfrequenz zwischen zwei Messfrequenzen erfolgt.

9.  Verfahren nach einem der Ansprüche 1 bis 8,
    **dadurch gekennzeichnet,**
    **dass** die Messfrequenz des Messsignals ($U_s$) vorzugsweise im Bereich von 80 Hz bis 150 kHz liegt.

**Claims**

1.  A method for monitoring a ground resistance ($R_{PE}$) of an electric installation (2) which consists of an ungrounded stationary alternating-voltage power supply system (4) having at least one active conductor (L1, L2, L3) and of a consumer (8) connected to the stationary alternating-voltage power supply system (4) via a supply line (6), the ungrounded stationary alternating-voltage power supply system (4) being supplied by a power transformer (12) and the consumer (8) comprising a leakage capacitor ($C_e$) connected to a protective conductor (PE),
    the method comprising the following steps:

    generating a measuring signal ($U_s$) having a measuring frequency by means of a measuring-signal generator (16),
    capacitively coupling the measuring signal ($U_s$) in the stationary alternating-voltage power supply system (4) between the active conductor (L1, L2, L3) and ground via a coupling circuit having a coupling capacitor ($C_s$) and having a series resistance ($R_{shunt}$),
    measuring a complex-valued first measuring current ($I_{m0}$) in the coupling circuit when the consumer (8) is switched off,
    detecting a complex-valued first measuring voltage ($U_{m0}$) between the active conductor (L1, L2, L3) and ground when the consumer (8) is switched off,
    determining a first complex-valued conductance value ($Y_{m0}$) from the first measuring current ($I_{m0}$) and the first measuring voltage ($U_{m0}$),
    measuring a second complex-valued measuring current ($I_{m1}$) in the coupling path when the consumer (8) is switched on,
    measuring a second complex-valued measuring voltage ($U_{m1}$) between the active conductor (L1, L2, L3) and ground when the consumer (8) is switched on,
    determining a second complex-valued conductance value ($Y_{m1}$) from the second measuring current ($I_{m1}$) and the second measuring voltage ($U_{m1}$),

computing a complex-valued load-side conductance value ($Y_v$) by forming a difference between the second conductance value ($Y_{m1}$) and the first conductance value ($Y_{m0}$),

computing a complex-valued load-side impedance ($Z_v$) from the inverse of the load-side conductance value ($Y_v$),

computing a sum ground resistance ($R'_{PE}$) by subtracting the series resistance ($R_{shunt}$) and loss resistances ($R_{ESR}$) of the leakage capacitor (Ce) and the coupling capacitor ($C_a$) from the real part of the complex-valued load-side impedance ($Z_v$),

generating an alarm signal if the sum ground resistance ($R'_{PE}$) exceeds a ground resistance threshold ($R_{PElim}$).

2. The method according to claim 1,
**characterized in that**
the first and second measuring current ($I_{m0}$, $I_{m1}$) are measured by tapping voltage at the series resistance ($R_{shunt}$) and at a current measuring circuit (50) which is parallel to the series resistance ($R_{shunt}$) and is realized as a high-pass filter having a current measuring capacitor ($C_1$) and a current measuring resistance ($R_1$).

3. The method according to claim 1 or 2,
**characterized in that**
the first and second measuring voltage ($U_{m0}$, $U_{m1}$) are detected by conducting a measurement by means of a capacitive voltage measuring circuit (30) which is realized as a high-pass filter having a voltage measuring capacitor ($C_h$) and a voltage measuring resistance ($R_2$).

4. The method according to claim 1 or 2,
**characterized in that**
the first and second measuring voltage ($U_{m0}$, $U_{m1}$) are detected by using a known measuring-signal generator voltage of the measuring-signal generator (16).

5. The method according to any one of the claims 1 to 4, **characterized in that**
the first conductance value ($Y_{m0}$) and second conductance value ($Y_{m1}$) are determined by computing Fourier coefficients (F{}) of the first and second measuring current ($I_{m0}$, $I_{m1}$) and the first and second measuring voltage ($U_{m0}$, $U_{m1}$).

6. The method according to any one of the claims 1 to 5, **characterized in that**
when the method is applied in a 3-phase ungrounded stationary alternating-voltage power supply system (4), the measuring signal (Us) is coupled in such a manner by means of the coupling circuit that a coupling capacitor ($C_a$) is switched in the coupling circuit for each active conductor (L1, L2, L3) and that the coupling circuit has the series resistance ($R_{shunt}$) as a shared coupling resistance.

7. The method according to any one of the claims 1 to 6, **characterized in that**
when the method is applied in a 3-phase ungrounded stationary alternating-voltage power supply system (4) with a power converter (70), the sum ground resistance ($R'_{PE}$) is computed by additionally subtracting differential diode resistances (n) of the power converter (70) and the loss resistances of power-converter leakage capacitors ($C_g$).

8. The method according to any one of the claims 1 to 7, **characterized in that**
the measuring frequency is switched between two measuring frequencies.

9. The method according to any one of the claims 1 to 8, **characterized in that**
the measuring frequency of the measuring signal (Us) preferably ranges from 80 Hz to 150 kHz.

**Revendications**

1. Procédé pour surveiller une résistance de terre ($R_{PE}$) d'une installation électrique (2) qui consiste en un système d'alimentation (4) à tension alternative stationnaire non mis à la terre ayant au moins un conducteur actif (L1, L2, L3) et un consommateur (8) relié au système d'alimentation (4) à tension alternative stationnaire par une connexion (6),

le système d'alimentation (4) à tension alternative stationnaire non mis à la terre étant alimenté en énergie par un transformateur de puissance (12) et le consommateur (8) comprenant un condensateur de fuite (Ce) relié à un conducteur de protection (PE),
le procédé comprenant les étapes suivantes :

générer un signal de mesure (Us) ayant une fréquence de mesure au moyen d'un générateur (16) du signal de mesure,

coupler de manière capacitive le signal de mesure (Us) dans le système d'alimentation (4) à tension alternative stationnaire entre le conducteur actif (L1, L2, L3) et la terre par circuit de couplage ayant un condensateur de couplage ($C_a$) et ayant une résistance série ($R_{shunt}$),

mesurer un premier courant de mesure ($I_{m0}$) de valeur complexe dans le circuit de couplage quand le consommateur (8) est coupé, détecter une première tension de mesure ($U_{m0}$) de valeur complexe entre le conducteur actif (L1, L2, L3) et la terre quand le consommateur (8) est coupé,

déterminer une première conductance ($Y_{m0}$) de valeur complexe du premier courant de mesure ($I_{m0}$) et de la première tension de mesure ($U_{m0}$),

mesurer un deuxième courant de mesure ($I_{m1}$) de valeur complexe dans le pas de couplage quand le consommateur (8) est raccordé,

mesurer une deuxième tension de mesure ($U_{m1}$) de valeur complexe entre le conducteur actif (L1, L2, L3) et la terre quand le consommateur (8) est raccordé,

déterminer une deuxième conductance ($Y_{m1}$) de valeur complexe du deuxième courant de mesure ($I_{m1}$) et de la deuxième tension de mesure ($U_{m1}$),

compter une conductance ($Y_v$) de valeur complexe du côté de la charge par la formation d'une différence entre la deuxième conductance ($Y_{m1}$) et la première conductance ($Y_{m0}$),

compter une impédance ($Z_v$) de valeur complexe du côté de la charge de l'inverse de la conductance ($Y_v$) du côté de la charge,

compter une résistance de terre ($R'_{PE}$) de somme en soustrayant la résistance série ($R_{shunt}$) et des résistances de pertes ($R_{ESR}$) du condensateur de fuite (Ce) et du condensateur de couplage ($C_a$) de la partie réelle de l'impédance ($Z_v$) de valeur complexe du côté de la charge,

générer un signal d'alarme si la résistance de terre ($R'_{PE}$) de somme surpasse un seuil de résistance de terre ($R_{PEiim}$).

2. Procédé selon la revendication 1,
   **caractérisé en ce que**
   le premier et le deuxième courant de mesure ($I_{m0}$, $I_{m1}$) sont mesurés par une prise de tension à la résistance série ($R_{shunt}$) et à un circuit (50) de mesure du courant qui est parallèle à la résistance série ($R_{shunt}$) et est réalisé comme filtre passe-haut ayant un condensateur de mesure ($C_1$) du courant et une résistance de mesure ($R_1$) du courant.

3. Procédé selon la revendication 1 ou la revendication 2, **caractérisé en ce que**
   la première et la deuxième tension de mesure ($U_{m0}$, $U_{m1}$) sont détectées par des mesures au moyen d'un circuit de mesure (30) capacitif de la tension, le circuit de mesure (30) de la tension étant réalisé comme filtre passe-haut ayant un condensateur de mesure ($C_h$) de la tension et une résistance de mesure ($R_2$) de la tension.

4. Procédé selon la revendication 1 ou la revendication 2, **caractérisé en ce que**
   la première et la deuxième tension de mesure ($U_{m0}$, $U_{m1}$) sont détectées en utilisant une tension de générateur connue du signal de mesure du générateur (16) du signal de mesure.

5. Procédé selon l'une quelconque la revendication 1 à 4, **caractérisé en ce que**
   la première conductance ($Y_{m0}$) et la deuxième conductance ($Y_{m1}$) sont déterminées en comptant des coefficients de Fourier (F{}) du premier et du deuxième courant de mesure ($I_{m0}$, $I_{m1}$) et de la première et de la deuxième tension de mesure ($U_{m0}$, $U_{m1}$).

6. Procédé selon l'une quelconque la revendication 1 à 5, **caractérisé en ce que**
   quand le procédé est mis en pratique dans un système d'alimentation (4) à tension alternative tripolaire stationnaire non mis à la terre, le signal de mesure ($U_s$) est couplé au moyen du circuit de couplage dans telle manière qu'un condensateur de couplage ($C_a$) est couplé dans le circuit de couplage pour chaque conducteur actif (L1, L2, L3) et dans telle manière que le circuit de couplage a la résistance série ($R_{shunt}$) comme résistance de couplage commune.

7. Procédé selon l'une quelconque la revendication 1 à 6, **caractérisé en ce que**
   quand le procédé est mis en pratique dans un système d'alimentation (4) à tension alternative tripolaire stationnaire non mis à la terre avec un convertisseur de puissance (70), la résistance de terre ($R'_{PE}$) de somme est comptée en soustrayant complémentairement des résistances de diode ($r_i$) différentielles du convertisseur de puissance (70) et des résistances de pertes des condensateurs de fuite ($C_g$) du convertisseur de puissance.

8. Procédé selon l'une quelconque la revendication 1 à 7, **caractérisé en ce que**
   la fréquence de mesure est couplée entre deux fréquences de mesure.

9. Procédé selon l'une quelconque la revendication 1 à 8, **caractérisé en ce que**
   la fréquence de mesure du signal de mesure (Us) varie de préférence dans une plage de 80 Hz à 150 kHz.

Fig. 1

**Fig. 2**

EP 3 862 763 B1

**Fig. 3**

Fig. 4

**Fig. 5**

EP 3 862 763 B1

**Fig. 6**

EP 3 862 763 B1

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012019094
- DE 102016202021
- DE 102013209142